# EUROPÄISCHE PATENTSCHRIFT

(11) **EP 2 934 804 B1**
(45) Veröffentlichungstag und Bekanntmachung des Hinweises auf die Patenterteilung: **28.02.2018**
(21) Anmeldenummer: 13807973.6
(22) Anmeldetag: 13.12.2013
(51) Int. Cl.: B23K 1/00, B23K 1/20, H01L 21/48, H05K 3/02, H05K 3/34

(54) **VERFAHREN ZUM VORBELOTEN VON METALLFLÄCHEN AUF METALLISIERTEN SUBSTRATEN UNTER ANWENDUNG EINES METALLGEWEBES ; METALLISIERTES SUBSTRAT MIT EINER LOTSICHT, DIE EINE OBERFLÄCHIGE STRUKTUR EINES GEWEBES AUFWEIST**
METHOD OF PRE-SOLDERING METAL SURFACES ONTO METALLISED SUBSTRATES USING A METALLIC GAUZE, METALLISED SUBSTRATE WITH A SOLDER LAYER WHICH HAS A SUPERFICIAL STRUCTURE OF A GAUZE
PROCÉDÉ DE DÉPÔT PRÉALABLE D'UNE BRASURE SUR DES SURFACES MÉTALLIQUES SUR DES SUBSTRATS MÉTALLISÉS AU MOYEN D'UN TISSU MÉTALLIQUE ; SUBSTRAT MÉTALLISÉ POURVU D'UNE COUCHE DE BRASURE, LAQUELLE PRÉSENTE UNE STRUCTURE SUPERFICIELLE D'UN TISSU

(30) Priorität: 18.12.2012 DE 102012223601
(43) Veröffentlichungstag der Anmeldung: 28.10.2015
(73) Patentinhaber: CeramTec GmbH, 73207 Plochingen (DE)
(72) Erfinder: HERRMANN, Klaus, 95707 Thiersheim (DE)
(74) Vertreter: Fehrenbacher, Eckhard Anton
(86) Internationale Anmeldenummer: PCT/EP2013/076466
(87) Internationale Veröffentlichungsnummer: WO 2014/095596

(56) Entgegenhaltungen:
- DE-A1-102011 013 928
- JP-A- H04 167 590
- US-A- 5 960 307

## Beschreibung

Die Erfindung betrifft ein Verfahren zum Vorbeloten von Metallflächen auf metallisierten Substraten und ein metallisiertes Substrat gemäß dem Oberbegriff der Ansprüche 1 und 8 (siehe z.B. DE 10 2011 013 928 A1). Elektrische Komponenten werden oft auf Metallflächen von metallisierten Substraten, wie metallisierte Keramiken oder metallkaschierte Kunststoffe oder Kunststoffplatinen (wie FR4) gesetzt. Besonders interessant sind Substrate mit Metallflächen, die bereits vorbelotet sind und deshalb zum Beispiel in einem Durchlaufofen gleich mit Komponenten bestückt werden können.

Besonders erwünscht ist eine Vorbelotung, die keinen üblichen Meniskus zeigt, so dass die aufgelegten zu verlötenden Komponenten nicht wackeln und wandern können. Bei der üblichen Vorbelotung der Metallflächen mit Lot, meist auf Basis Nickel oder Silber oder Silber/Palladium, mit siebgedruckten Lotkugeln oder mit Lotfolienstanzlingen bildet das flüssige Lot einen deutlichen Randwinkel.

Bisher werden die Lot-Preformen in komplizierten Formen beim Schmelzen flach gedrückt, was aber dennoch zu unbefriedigenden Oberflächen führt.

Der Erfindung liegt die Aufgabe zugrunde, ein Verfahren nach dem Oberbegriff des Anspruchs 1 und ein metallisiertes Substrat nach dem Oberbegriff des Anspruchs 8 so zu verbessern, dass eine definierte gleichmäßige Höhe der Lotschicht erzielt wird und es nicht zur Bildung von aufgewölbtem Lot kommt. Weiterhin sollen selbst dickere Lotschichten um 100 µm mit einer Dickenschwankung unter 20 µm bis zum Rand der Lotschicht erzeugt werden. Auch eine Porenbildung in der Lotschicht soll minimiert werden.

Erfindungsgemäß wird diese Aufgabe durch die Merkmale des Anspruchs 1 und durch die Merkmale des Anspruchs 8 gelöst. Dadurch, dass beim Beloten bzw. Aufschmelzen auf die Lot-Preformen flach ein Metallgewebe gedrückt wird und das Metallgewebe aus einem nicht lotbenetzenden Material besteht, wird eine definierte gleichmäßige Höhe der Lotschicht erzielt und es kommt nicht zur Bildung von aufgewölbtem Lot. Außerdem werden selbst dickere Lotschichten um 100 µm mit einer Dickenschwankung unter 20 oder sogar unter 15 µm bis zum Rand der Lotschicht erzeugt. Auch eine Porenbildung in der Lotschicht soll minimiert werden. Dadurch kann in einem späteren Prozess das elektriche oder elektronische Bauteil, wie ein Chip/Transistor etc. auf eine gleichmässig starke Lotschicht aufgelegt werden. Die Wärmeleitung vom Bauteil in das Substrat wird gleichmässiger und berechenbarer.

Der Begriff Lot-Preformen umfasst in dieser Beschreibung auch nur eine einzige Lot-Preform. Metallgewebe werden auch als metallische Siebgewebe bezeichnet und zum Beispiel beim Siebdruck verwendet.

Das Metallgewebe sollte möglichst flach auf die Lot-Preformen aufgedrückt werden (bevorzugt gespannt) sein, damit die Lotschicht gleichmäßig hoch wird.

Der Erfindung liegt die Idee zugrunde, dass man mit Hilfe eines flachen bevorzugt gespannten Metallgewebe (wie es beispielsweise beim Siebdruck verwendet wird) aus einem geeigneten, nicht lotbenetzenden Material, das aufschmelzende Lot flach drückt.

Durch die Öffnungen im Metallgewebe kann das Gas im Lötofen entweichen und bildet keine Blasen im Lot oder auf der Oberfläche der Lotschicht.

Das Metallgewebe besteht aus einem nicht lotbenetzenden Material, so dass es sich nicht mit den üblichen Weichloten auf Zinnbasis verbindet. Außerdem verzundert das Metallgewebe in neutraler oder reduzierender Atmosphäre nicht. Das Metallgewebe ist bevorzugt ein Edelstahlgewebe.

Mit der Dicke oder Höhe des Metallgewebes lässt sich die Dicke oder Höhe der Lotschicht auf den Metallflächen definiert einstellen.

Bevorzugt werden als Lot-Preformen flache blattförmige Lotstanzteile verwendet, die leicht auf den Metallflächen platziert werden können und die es in jeder gewünschten Dicke gibt. Die verwendbaren Lote sind bevorzugt moderne bleifreie Weichlote wie beispielsweise die Gruppe der Lote SnCuₓAg_{y}. Bevorzugt besteht das Lot aus SnAg₃Cu_{0.5}. Gemäß der Erfindung werden die Höhe (Dicke) der Lot-Preformen und das Volumen zwischen den Metallfäden des Metallgewebes so aufeinander abgestimmt, dass das aufschmelzende Lot maximal dieses Volumen füllt, aber nicht "überläuft" und zur Seite gedrückt wird über den Rand der Metallflächen hinaus. Werden zu hohe Lot-Preformen verwendet, so tritt ein "Überlaufen" ein. Werden zu niedrige bzw. zu dünne Lot-Preformen verwendet, füllt das Lot den Raum zwischen den Metallfäden des Metallgewebes nicht vollständig aus, so dass die Höhe der späteren Lotschicht nicht definiert ist.

Bei einem Substrat mit beidseitigen Metallflächen wird in einer bevorzugten Ausführungsform des Verfahrens zum Beloten ein Sandwich aus folgenden übereinander angeordneten Teilen gebildet:
a. einer flachen Grundplatte, bevorzugt aus Keramik
b. Metallgewebe
c. Lot-Preformen
d. Substrat mit beidseitigen Metallflächen
e. Lot-Preformen
f. Metallgewebe
g. flache Deckplatte, bevorzugt aus Keramik.

Dieses Sandwich, ggf. noch unter Druck, wird in einem Ofen erhitzt, bis die Lot-Preformen schmelzen und das aufgeschmolzene Lot die Metallflächen beloten.

Danach wird das Sandwich aus dem Ofen genommen und abgekühlt. Zuletzt wird das Metallgewebe vom Substrat abgenommen und kann wiederverwendet werden.

Bei einem Substrat mit Metallflächen auf nur einer Seite entfallen die Ziffern e und f, d.h. auf die Seite das Substrats ohne Metallflächen wird direkt die Deckplatte gelegt.

Bevorzugt liegt die Maschenweite des Metallgewebes zwischen 300 und 450 mesh, bevorzugt bei 325 mesh oder 400 mesh. Bei diesen Maschenweiten wurden die besten Resultate erzeugt. Bevorzugt sind Edelstahlgewebe wie VA325 oder VA280 (die Zahl beschreibt die Fädenzahl pro Zoll).

Bei dem erfindungsgemäßen metallisierten Substrat mit beloteten Metallflächen, insbesondere hergestellt mit dem eben beschriebenen Verfahren, weist die Lotschicht auf den Metallflächen eine oberflächliche Struktur in der Art eines Gewebes auf. Die Lotschicht weist gemäß der Erfindung eine gleichmässige Höhe und keine Aufwölbungen auf. Die Dickenschwankung der Lotschicht auf den Metallflächen liegt unter 20 µm.

Die Erfindung beschreibt somit auch ein Verfahren, wie die Vorbelotung ausgeführt werden kann um dabei flache Lotdepots in definierter gleichmässiger Stärke auf einem Substrat zu erhalten. Das Verfahren kann sowohl zum einseitigen wie zum beidseitigen Beloten von Substraten verwendet werden.

Weitere Merkmale der Erfindung ergeben sich aus den Figuren, die nachfolgend beschrieben werden.

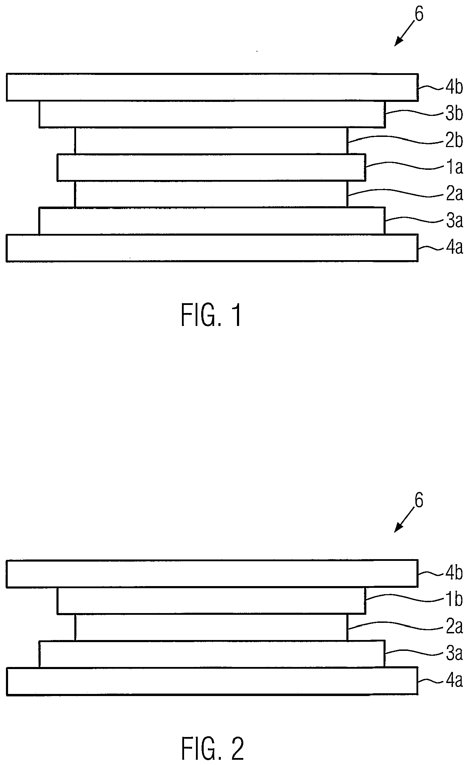

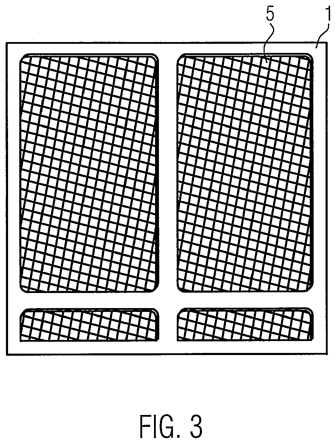

Figur 1 zeigt eine Schmelzform bzw. ein Sandwich 6, mit dem eine Belotung bzw. eine Lotschicht 5 (siehe Figur 3) auf Metallflächen eines metallisierten Substrats 1 gebracht wird. Die Schmelzform bzw. das Sandwich 6 besteht aus folgenden Teilen, die aufeinander geschichtet sind.

Die einzelnen Schichten bzw. Teile des Sandwichs 6 in den Figuren 1 und 2 sind nicht maßstabsgetreu abgebildet. Es soll nur die Schichtung bzw. der Aufbau der Schmelzform verdeutlicht werden.

Zuunterst befindet sich eine flache Grundplatte 4a, aus Graphit, Aluminium oder Keramik. Keramik ist bevorzugt. Darauf liegt ein Metallgewebe 3a aus einem nicht lotbenetzenden Material. Hier ist es ein Stahlgewebe, d.h. ein Metallgewebe 3a aus einzelnen Stahlfäden. Die Maschenweite dieses Metallgewebes 3a beträgt 325 mesh oder 400 mesh. Das Metallgewebe 3a ist bevorzugt gespannt. Zum Beispiel kann es auf der Grundplatte 4a gespannt befestigt sein. Es kann jedoch auch einfach auf die Grundplatte 4a gelegt werden, da das Sandwich 6 beim Beloten durch die Platten 4a, 4b beschwert wird, oder zusätzlich noch eingespannt wird.

Auf dem Metallgewebe 3a ist eine Lot-Preform 2a oder sind mehrere Lot-Preformen angeordnet. Die einzelnen Lot-Preformen 2 müssen an den Orten der zu belotenden Metallflächen der Substrate 1 angeordnet werden.

Mit dem Bezugszeichen 1a, 1b sind in den Figuren die metallisierten Substrate mit ihren Metallflächen bezeichnet. Die Schmelzform bzw. das Sandwich in Figur 1 weist ein Substrat 1a mit Metallflächen auf beiden Seiten auf.

Zur Belotung der anderen Seite des Substrats 1a wird auf diesem eine Lot-Preform 2b oder mehrere Lot-Preformen angeordnet. Auf diese Lot-Preform 2b wird ein weiteres Metallgewebe 3b gelegt. Zuoberst auf dem Sandwich 6 ist eine flache Deckplatte 4b angeordnet.

Figur 2 zeigt eine Schmelzform bzw. ein Sandwich zur Belotung nur einer Seite eines Substrats.

Zuunterst befindet sich eine flache Grundplatte 4a aus einer Keramik. Darauf liegt ein Metallgewebe 3a aus einem nicht lotbenetzenden Material, hier ein Stahlgewebe. Die Maschenweite dieses Metallgewebes 3a beträgt 325 mesh oder 400 mesh. Das Metallgewebe 3a ist auf der Grundplatte 4a gespannt befestigt (in der Figur nicht zu erkennen). Es kann jedoch auch einfach auf die Grundplatte 4a gelegt werden, da das Sandwich 6 beim Beloten durch die Platten beschwert wird, oder zusätzlich noch eingespannt wird.

Auf dem Metallgewebe 3a ist eine Lot-Preform 2a oder sind mehrere Lot-Preformen angeordnet. Die einzelnen Lot-Preformen 2 müssen an den Orten der zu belotenden Metallflächen der Substrate 1 angeordnet werden.

Mit dem Bezugszeichen 1b ist das zu belotende Substrat bezeichnet. Die Schmelzform bzw. das Sandwich 6 in Figur 1 weist ein Substrat 1b mit Metallflächen nur auf einer Seite auf. Abgedeckt wird das Sandwich mit einer Deckplatte 4b, hier aus Keramik.

Außerdem ist in allen Beispielen das Substrat vormetallisiert mit W-Glas + NiP (eventuell auch noch + Au).

Zum Beloten wird das Sandwich z.B. in einem Gliederbandofen oder in einem Batchofen oder anderen Heizaggregaten (IR-Ofen o.ä.) behandelt.

Die Ofenatmosphäre muss an die Materialien angepasst sein, sie besteht vorzugsweise aus Stickstoff oder einem Gemisch aus Stickstoff und Wasserstoff. Die Spitzentemperatur im Ofen ist an das Lot angepasst und liegt vorzugsweise im Bereich 300-600°C, die Schmelzzeit des Lots muss möglichst kurz gehalten werden, sie liegt unterhalb von 5 min.

Metallisierte Substrate sind zum Beispiel metallisierte Keramiken oder metallkaschierten Kunststoffe bzw. Kunststoffplatinen.

Grundsätzlich wird beim Beloten eine ebene (z.B. geschliffene) Platte 4a, 4b, bevorzugt aus Keramik einseitig mit einem Metallgewebe aus Edelstahl flach belegt oder bespannt. Auf das flache Metallgewebe legt man an definierte Stellen die Lot-Preforms, also flache blattförmige Lotstanzteile. Das kann mit einem Roboter geschehen. Dann plaziert man das zu belotende Substrat mit seiner Grundmetallisierung wie W-Ni oder Cu-Ni oder ähnlich auf die Lot-Preforms.

Ist das Substrat beidseitig metallisiert, kann man jetzt auch auf die zu belotenden Flächen der Oberseite Lot-Preforms legen. Dann wird auch auf die belegte Oberseite ein Metallgewebe gelegt und eine flache Keramikplatte als Deckplatte 4b.

Das "Sandwich" kann durch weitere Gewichte zur Verbesserung des Kontaktes zusätzlich noch beschwert werden. Das Sandwich wird dann durch einen Ofen gefahren und die Lot-Preforms werden aufgeschmolzen. Die Stärke des Lot-Preforms und das "Farbvolumen" des Metallgewebes sind so aufeinander abgestimmt, dass das Lot maximal den leeren Raum zwischen den Metallfäden füllt, aber nicht "überläuft" und zur Seite gedrückt wird über den Rand des zu belotenden Metallflächen hinaus. Durch die untere Grundplatte 4a und obere Deckplatte 4b wird die Lotoberfläche abgeplattet.

Hintergrund des Verfahrens ist die schlechte Benetzung von Edelstahl (Metallgewebe) durch viele zinnhaltige Lote. So kann man nach der Vorbelotung das Metallgewebe aus dem wieder erstarrten Lot einfach abziehen und wieder verwenden.

Die Strukturgebung der Lotschicht durch ein nicht benetzendes Hilfmittel, hier ein Metallgewebe bzw. ein Siebgewebe, mit dem man auch zusammen mit der Höhe oder Stärke der Lot-Preforms die Lotstärke steuern kann, ist ein wichtiges Mertkmal der Erfindung.

Figur 3 zeigt die Lotschicht auf einem erfindungsgemäßen Substrat 1 mit einer Lotschicht 5. Die Lotschicht 5 ist auf den Metallflächen (unter der Lotschicht 5, daher nicht zu sehen) angeordnet und weist eine oberflächliche Struktur in der Art eines Gewebes auf.

Die Lotschicht 5 weist eine gleichmässige Höhe und keine Aufwölbungen auf. Die Dickenschwankung der Lotschicht 5 auf den Metallflächen liegt unter 20 µm, bevorzugt unter 15 µm.

## Patentansprüche

1. Verfahren zum Vorbeloten von Metallflächen auf metallisierten Substraten (1a, 1b), wobei Lot-Preformen (2a, 2b) auf die Metallflächen der Substrate (1a, 1b) gelegt werden oder umgekehrt und anschließend die Lot-Preformen (2a, 2b) aufgeschmolzen werden, wodurch die Metallflächen mit dem Lot der Lot-Preformen (2a, 2b) belotet werden und das Lot eine Lotschicht (5) bildet, **dadurch gekennzeichnet, dass** beim Beloten bzw. Aufschmelzen auf die Lot-Preformen (2a, 2b) flach ein Metallgewebe (3a, 3b) gedrückt wird und das Metallgewebe (3a, 3b) aus einem nicht lotbenetzenden Material besteht, wobei die Höhe der Lot-Preformen (2a, 2b) und das Volumen zwischen den Metallfäden des Metallgewebes (3a, 3b) so aufeinander abgestimmt werden, dass das aufschmelzende Lot maximal dieses Volumen füllt, aber nicht "überläuft" und zur Seite gedrückt wird über den Rand der Metallflächen hinaus.

2. Verfahren nach Anspruch 1, **dadurch gekennzeichnet, dass** als Lot-Preformen (2a, 2b) flache blattförmige Lotstanzteile verwendet werden.

3. Verfahren nach Anspruch 1 oder 2, **dadurch gekennzeichnet, dass** das Metallgewebe (3a, 3b) ein Edelstahlgewebe ist.

4. Verfahren nach einem der Ansprüche 1 bis 3, **dadurch gekennzeichnet, dass** bei einem Substrat (1a) mit beidseitigen Metallflächen zum Beloten ein Sandwich (6) gebildet wird aus folgenden übereinander angeordneten Teilen
a. einer flachen Grundplatte (4a), bevorzugt aus Keramik
b. Metallgewebe (3a)
c. Lot-Preformen (2a)
d. Substrat (1a) mit beidseitigen Metallflächen
e. Lot-Preformen (2b)
f. Metallgewebe (3b)
g. flache Deckplatte (4b), bevorzugt aus Keramik
und dieses Sandwich (6), ggf. noch unter Druck, in einem Ofen erhitzt wird bis die Lot-Preformen (2a, 2b) schmelzen und das aufgeschmolzene Lot die Metallflächen beloten und danach das Sandwich aus dem Ofen genommen und abgekühlt wird und die Metallgewebe (3a, 3b) vom Substrat (1a) abgenommen und wiederverwendet werden können.

5. Verfahren nach Anspruch 4, **dadurch gekennzeichnet, dass** bei einem Substrat (1b) mit Metallflächen auf nur einer Seite die Ziffern e und f entfallen.

6. Verfahren nach einem der Ansprüche 1 bis 5, **dadurch gekennzeichnet, dass** die Maschenweite des Metallgewebes (3a, 3b) zwischen 300 und 450 mesh, bevorzugt bei 325 mesh oder 400 mesh liegt.

7. Verfahren nach einem der Ansprüche 1 bis 6, **dadurch gekennzeichnet, dass** die Lot-Preformen (2a, 2b) aus SnAg₃Cu_{0.5} bestehen.

8. Metallisiertes Substrat mit beloteten Metallflächen, insbesondere hergestellt mit dem Verfahren nach einem der Ansprüche 1 bis 7, **dadurch gekennzeichnet, dass** die Lotschicht (5) eine gleichmässige Höhe und keine Aufwölbungen aufweist und die Lotschicht (5) auf den Metallflächen eine oberflächliche Struktur in der Art eines Gewebes aufweist.

9. Metallisiertes Substrat nach Anspruch 8, **dadurch gekennzeichnet, dass** die Dickenschwankung der Lotschicht (5) auf den Metallflächen unter 20 µm, bevorzugt unter 15 µm liegt.

## Claims

1. A method for pre-soldering metal surfaces on metallized substrates (1a, 1b), wherein solder preforms (2a, 2b) are laid on the metal surfaces of the substrates (1a, 1b) or *vice versa* and subsequently the solder preforms (2a, 2b) are melted thereon, whereby the metal surfaces are soldered with the solder of the solder preforms (2a, 2b), and the solder forms a layer of solder (5), **characterised in that**, during the soldering or melting-on, a metal gauze (3a, 3b) is pressed flat onto the solder preforms (2a, 2b), and the metal gauze (3a, 3b) consists of a non-solder-wetting material, wherein the height of the solder preforms (2a, 2b) and the volume between the metal threads of the metal gauze (3a, 3b) are matched to each other in such a way that the solder melting thereon maximally fills this volume, but does not "overflow" and is not pressed to the side beyond the edge of the metal surfaces.

2. A method according to claim 1, **characterised in that** flat sheet-like stamped solder portions are used as the solder preforms (2a, 2b).

3. A method according to claim 1 or 2, **characterised in that** the metal gauze (3a, 3b) is a stainless-steel gauze.

4. A method according to one of claims 1 to 3, **characterised in that**, in the case of a substrate (1a) having metal surfaces on both sides for soldering, a sandwich (6) is formed from the following portions arranged one on top of the other:
a. a flat base plate (4a), preferably of ceramic material,
b. metal gauze (3a)
c. solder preforms (2a)
d. substrate (1a) with metal surfaces on both sides
e. solder preforms (2b)
f. metal gauze (3b)
g. flat cover plate (4b), preferably of ceramic material,
and this sandwich (6), if applicable still under pressure, is heated in a furnace until the solder preforms (2a, 2b) melt and the melted-on solder solders the metal surfaces, and afterwards the sandwich is taken from the furnace and cooled, and the metal gauzes (3a, 3b) can be removed from the substrate (1a) and reused.

5. A method according to claim 4, **characterised in that**, in the case of a substrate (1b) having metal surfaces on just one side, items e and f are omitted.

6. A method according to one of claims 1 to 5, **characterised in that** the mesh width of the metal gauze (3a, 3b) lies between 300 and 450 mesh, preferably at 325 mesh or 400 mesh.

7. A method according to one of claims 1 to 6, **characterised in that** the solder preforms (2a, 2b) consist of SnAg₃Cu_{0.5}.

8. A metallized substrate having soldered metal surfaces, in particular produced with the method according to one of claims 1 to 7, **characterised in that** the layer of solder (5) has a uniform height and no bulges, and the layer of solder (5) on the metal surfaces has a surface structure in the manner of a gauze.

9. A metallized substrate according to claim 8, **characterised in that** the variation in thickness of the layer of solder (5) on the metal surfaces lies below 20 µm, preferably below 15 µm.

## Revendications

1. Procédé visant à pré-enduire de soudure des surfaces métalliques sur des substrats métallisés (1a, 1b), dans lequel on dispose des préformes de soudure (2a, 2b) sur les surfaces métalliques des substrats (1a, 1b), ou l'inverse, et l'on fait ensuite fondre les préformes de soudure (2a, 2b), grâce à quoi les surfaces métalliques sont enduites avec la soudure des préformes de soudure (2a, 2b) et la soudure forme une couche de soudure (5), **caractérisé en ce que**, lors de l'enduction de soudure ou de la fusion de celle-ci, on presse à plat sur les préformes de soudure (2a, 2b) une toile métallique (3a, 3b), laquelle toile métallique (3a, 3b) est faite d'un matériau que la soudure ne mouille pas, étant entendu que la hauteur des préformes de soudure (2a, 2b) et le volume compris entre les fils métalliques de la toile métallique (3a, 3b) sont si bien accordés l'un à l'autre que la soudure en fusion remplit ce volume au maximum, mais ne déborde pas et n'est pas pressée sur les côtés au-dehors, par-dessus le bord de la surface métallique.

2. Procédé conforme à la revendication 1, **caractérisé en ce que** l'on utilise, en tant que préformes de soudure (2a, 2b), des découpes de soudure planes, en forme de feuille.

3. Procédé conforme à la revendication 1 ou 2, **caractérisé en ce que** la toile métallique (3a, 3b) est une toile en acier inoxydable.

4. Procédé conforme à l'une des revendications 1 à 3, **caractérisé en ce que**, dans le cas d'un substrat (1a) portant sur ses deux faces des surfaces métalliques à enduire de soudure, on forme un sandwich (6) avec les éléments suivants disposés les uns sur les autres :
a) une plaque de dessous (4a) plane, de préférence en céramique,
b) une toile métallique (3a),
c) une préforme de soudure (2a),
d) le substrat (1a), avec des surfaces métalliques sur les deux faces,
e) une préforme de soudure (2b),
f) une toile métallique (3b),
g) et une plaque de dessus (4b) plane, de préférence en céramique,
et l'on chauffe dans un four ce sandwich (6), éventuellement encore sous pression, jusqu'à ce que les préformes de soudure (2a, 2b) fondent et que la soudure fondue enduise les surfaces métalliques, et l'on sort ensuite le sandwich du four et on le fait refroidir, puis on sépare du substrat (1a) les toiles métalliques (3a, 3b) qu'on peut alors réutiliser.

5. Procédé conforme à la revendication 4, **caractérisé en ce que**, dans le cas d'un substrat (1b) portant des surfaces métalliques sur une seule face, les éléments (e) et (f) sont absents.

6. Procédé conforme à l'une des revendications 1 à 5, **caractérisé en ce que** l'ouverture de maille de la toile métallique (3a, 3b) se situe entre 300 et 450 mesh, et vaut de préférence 325 ou 400 mesh.

7. Procédé conforme à l'une des revendications 1 à 6, **caractérisé en ce que** les préformes de soudure (2a, 2b) sont en alliage de formule SnAg₃Cu_{0,5}.

8. Substrat métallisé à surfaces métalliques enduites de soudure, en particulier préparé selon un procédé conforme à l'une des revendications 1 à 7, **caractérisé en ce que** la couche de soudure (5) présente une hauteur régulière et ne présente pas de bombements, et **en ce que** la couche de soudure (5) présente, sur les surfaces métalliques, une structure de surface à la manière d'une toile.

9. Substrat métallisé conforme à la revendication 8, **caractérisé en ce que** les variations de l'épaisseur de la couche de soudure (5) sur les surfaces métalliques sont inférieures à 20 µm, et de préférence, inférieures à 15 µm.
